# EUROPEAN PATENT APPLICATION

(11) **EP 2 866 316 A1**
(43) Date of publication of application: **29.04.2015**
(21) Application number: 13306460.0
(22) Date of filing: 23.10.2013
(51) Int. Cl.: H01S 5/223, H01S 5/02, H01S 5/026, H01S 5/10, H01S 5/024, H01S 5/028

(54) **Thermal management of a ridge-type hybrid laser, device, and method**

(71) Applicant: ALCATEL LUCENT, 92100 Boulogne-Billancourt (FR)
(72) Inventor: Enright, Ryan, 15 Dublin (IE); Mathews, Ian, 15 Dublin (IE)
(74) Representative: Coghlan, Judith Elizabeth Kensy

(57) **Abstract**

Aspects and embodiments relate to a device and method for providing a device. The device comprises: a ridge-type hybrid laser; and a thermally conductive, electrically insulating, coating adjacent a surface of the ridge-type hybrid laser; the coating being configured to transfer heat away from the laser. It will be appreciated that aspects and embodiments recognise that a thermal solution can be implemented to enable energy efficient, scalable, reliable and low cost cooling designs for integrated photonics devices. An arrangement in accordance with aspects and embodiments described herein can provide improved thermal performance of a hybrid ridge type laser device. Such improved thermal performance can facilitate better temperature control, and lower device temperature can result in better device performance and longer device lifetimes. Aspects and embodiments help to provide an integrated thermal approach which can deal with thermal spreading close to where heat on a device is generated within a laser waveguide.

## Description

### FIELD OF THE INVENTION

Aspects and embodiments relate to a device and method for providing a device.

### BACKGROUND

Thermal management of small scale integrated devices can be a barrier to enabling a large increase in manageable data traffic. In photonic integrated circuits (PICs) and opto-electronic integrated circuits (ICs) there are integrated devices whose large heat flux levels require management. Those large heat flux levels (for example, greater than 1000W/cm²) result in the need to remove heat from the integrated circuit. Some integrated devices and components included on an integrated circuit may be highly temperature sensitive and, as a result, the temperature of those devices may need to be actively managed or controlled. For some devices that temperature control must be performed within tight limits; for example, within a tolerance of 0.1°C. Temperature control may be necessary on an individual and independent component basis.

In the case of some integrated circuits, integration may be limited by poor efficiency of photonic-based communication. Such efficiency is typically measured in terms of energy consumed per bit of information passed (J/bit). The efficiency of photonic-based communication at short length scales when compared to electronic-based communication may be judged to be poor. If exaflop computing is to become a reality, there is a requirement to provide high bandwidth chip-to-chip communication across a small length scale. As a result, device integration densities are likely to be increased to accommodate such bandwidth requirements. In order for such bandwidth requirements to be enabled optically, energy consumption associated with active photonics devices should be significantly reduced in order to overtake electronic arrangements at increasingly smaller length scales. Advanced thermal management concepts have a role to play in reducing energy consumption in photonics and other integrated circuits.

### SUMMARY

It is desired to provide an integrated circuit which addresses some issues with known integrated circuits.

Accordingly, a first aspect provides a device comprising: a ridge-type hybrid laser; and a thermally conductive, electrically insulating, coating adjacent a surface of the ridge-type hybrid laser; the coating being configured to transfer heat away from the laser.

The first aspect recognises that in terms of thermal management of integrated circuit devices there are a number of significant issues. Some devices and components formed on an integrated circuit may generate significant heat loads in very small areas and therefore have large heat flux levels. Those heat flux levels may, for example, be greater than 1000W/cm². Such large heat flux may need to be removed in order to ensure reliable operation of a device.

The first aspect also recognises that operation of some components may depend upon the temperature of those components and that thermal management of those components may improve component and/ or device operation. For example, some active opto-electronic components such as lasers may require that their operational temperature be controlled to within tight operating temperature boundaries. Such boundaries may, for example, be of the order of 0.1C. In the case of lasers provided on an integrated circuit, the absolute operating temperature of the laser is a determining factor in its output efficiency and spectral output. It will therefore be appreciated that lowering the operational temperature of the laser component or device on an integrated circuit may provide a means to provide an order of magnitude improvement in operating efficiency and control of the spectral output.

The first aspect recognises that some issues may be addressed, in part, by improving the thermal resistance characteristics of individual devices. This is especially true for hybrid III-V photonics-on-silicon devices which are typically doped III-V materials containing multi quantum well (MQW) layers for communication applications.

The first aspect recognises that hybrid laser technology has become increasingly important since it provides a route to introduce light generating devices onto silicon substrates and to enable opto-electronic integration which is complementary metal-oxide-semiconductor (CMOS) compatible.

The first aspect recognises that hybrid laser devices typically have poorer thermal characteristics than comparable traditional monolithic III-V based photonic integrated circuits where laser architectures buried in III-V material are standard. Poor thermal performance in such arrangements is due to employed fabrication methods. According to such methods, polymers such as benzocyclobutene (BCB) are often used to both attach III-Vbased materials to silicon-on-insulator (SOI) wafers and to encapsulate the waveguide of the III-V device. Those polymers are typically favoured due to their dielectric and optical properties. However, their poor thermal properties result in the overall thermal resistance of hybrid devices being relatively large. Such a high thermal resistance can result in an excessive temperature rise within a waveguide structure associated with the laser and can lead to poorer efficiency in thermoelectric-based cooling approaches due to the need to generate larger temperature differences to facilitate acceptable device operation temperatures. It will be appreciated that aspects recognises that although it is possible to bond the hybrid laser structure to a substrate using DVS BCB, it is also possible to bond the laser structure to a substrate by direct bonding or by using a buried oxide or nitride layer.

The first aspect provides a device. That device may comprise a semiconductor device. That device may comprise a photonic integrated device. The device may comprise an integrated circuit.

The device may comprise a ridge-type hybrid laser. The ridge-type hybrid laser may comprise a hybrid silicon laser. The hybrid laser may be fabricated on a substrate from appropriately doped group III-V semiconductor materials. The laser may be fabricated on a substrate. The substrate may comprise a silicon wafer. The laser may be electrically driven. The laser may be integrated with other photonic devices.

At least one surface of the laser may be provided with a coating. The coating may be arranged directly adjacent the hybrid laser. That is to say, the coating may be in direct contact with a surface of the laser. Such an arrangement may allow for efficient transfer of heat away from the laser. The coating may be selected to have a thermal resistance lower than that of air. The coating may be selected to have a thermal resistance lower than that of the hybrid laser, such that heat flows away from the laser into the coating. The coating may be electrically insulating. The coating may span between an anode and cathode or other electrical connections associated with the laser. Accordingly, the coating may act to inhibit or prevent electrical conduction between such connections.

The coating may be arranged to transfer heat away from the laser. The placing of the coating may allow for heat transfer away from the laser. The coating may transfer heat away from the laser to a region from which heat may be extracted. The coating may be located or placed such that it operates to spread the heat from the laser over a region of a substrate, from which heat may be extracted. The coating may be located or placed such that it operates to transfer the heat from the laser to a cool side of a thermoelectric module which may act to extract heat from the device. The coating may be located or placed such that it operates to spread the heat for removal from the device by an appropriately chosen cooling mechanism.

The coating may comprise a thin deposited layer of material. The coating may have a thickness comparable to the width of the ridge of the ridge-type laser. The coating may comprise a material in which the laser is substantially embedded.

The coating may comprise a plurality of layers. The layers may comprise identical materials having a different crystalline form. The layers may comprise non-identical materials. The layers closest to the surface of the laser device may protect the laser device from temperatures associated with deposition of subsequent layers of coating.

Any material having a thermal conductivity greater than about 1W/mK (Watts per metre Kelvin) may be considered a thermally conductive material. Conversely, any material having a thermal conductivity of less than about 1W/mK may be considered to be substantially non-thermally conductive. Within the thermal conductivity range described above, a thermal conductivity greater than 100W/mK may be considered as a high thermal conductivity material and one within the range 1-100W/mK may be considered to have an acceptable thermal conductivity value. In one embodiment, the coating has a thermal conductivity greater than about 1W/mK.

In one embodiment, the device comprises a substrate upon which the laser is arranged; the coating being configured to transfer heat away from said laser toward the substrate. The coating may be located or placed such that it operates to spread the heat from the laser over a region of a substrate, from which heat may be extracted. The coating may be located or placed such that it operates to transfer the heat from the laser to a cool side of a thermoelectric module which may act to extract heat from the device. The coating may be located or placed such that it operates to spread the heat for removal by an appropriately chosen cooling mechanism from the substrate.

In one embodiment, the coating is adjacent a portion of the surface. Accordingly, the coating may be provided such that the whole of a surface is coated. A portion of a surface of the laser may be coated. More than one surface of the laser may be coated. Accordingly, heat transfer away from the heat-generating laser may be implemented.

In one embodiment, the coating is adjacent an active region of the ridge-type hybrid laser. Accordingly, the coating may be placed immediately adjacent a region of the laser which generates heat. It will be appreciated that by minimising distance between a region of heat generation and a means to transfer heat away from that region, efficient heat transfer maybe achieved.

In one embodiment, the coating surrounds the active region. In one embodiment, the coating encapsulates the active region. Accordingly, the coating may be provided such that it substantially surrounds or encapsulates the laser. If surrounding the laser, at least one periphery of the laser may be coated. If encapsulated, substantially all surfaces may be coated of the laser may be coated. The laser acts as a heat generating element of the device and by surrounding or encapsulating the heat generating element with a means to transfer heat away, thermal control of the heat generating element may be achieved. Thermal control of such an element may allow for control of other functionality of the element.

In one embodiment, the coating is arranged between the surface and a substrate on which the ridge-type laser is arranged. As a result of the construction of a ridge-type hybrid laser, if an element is to be provided adjacent a surface of the laser to transfer heat away from that laser surface, there may be a need for the material to be electrically insulating to prevent electrical shorting between an anode and cathode associated with operation of the laser. In one embodiment, the coating is configured to prevent electrical conduction between an anode and cathode pair associated with the ridge-type hybrid laser.

In one embodiment, the coating has a refractive index selected to prevent leakage of light from the ridge-type hybrid laser. Since the purpose of a ridge type laser is that of generation of light, the material may be selected to minimise leakage of light from the laser waveguide. In other words, the material can be selected to minimise coupling of light from the laser to the coating material.

In one embodiment, the coating comprises: a crystalline, polycrystalline or amorphous material selected to have deposition characteristics which prevent damage, during deposition, to the laser. The coating material may have mechanical properties selected to allow the coating to protect the ridge-type laser as appropriate. For example, the material may be selected to have a coefficient of thermal expansion matched to that of the ridge type laser, thereby mitigating chances of inducing mechanical strain damage to the laser, including, for example, strain induced layer separation or fracturing of the material forming the coating or the laser itself.

The coating material may be selected such that deposition techniques utilised to apply the coating to the surface of the laser are unlikely to cause damage to the laser construction. Deposition techniques typically require significant deposition temperatures. Such temperatures may exceed a temperature at which thermal damage may occur to said ridge laser. Such thermal damage may, for example, include delamination or separation of components forming said ridge type laser, or may include dopant diffusion from doped regions of said laser, resulting in functional damage to the operation of the laser.

In one embodiment, the coating comprises: a material selected to have a coefficient of thermal expansion matched to that of the laser. Accordingly, failure of the laser during operation or during coating deposition due to thermally induced strain between the coating and the laser may be prevented.

A second aspect provides a method of providing a device, the method comprising: providing a ridge-type hybrid laser; and coating a surface of the ridge-type hybrid laser with a thermally conductive, electrically insulating coating, the coating being adjacent the surface; and configuring the coating to transfer heat away from the laser.

In one embodiment, the method comprises: coating a portion of the surface.

In one embodiment, the method comprises: arranging the coating to be adjacent an active region of the ridge-type hybrid laser.

In one embodiment, the method comprises: arranging the coating to surround the active region.

In one embodiment, the method comprises: arranging the coating to encapsulate the active region.

In one embodiment, the method comprises: arranging the coating between the surface and a substrate on which the ridge-type laser is arranged.

In one embodiment, the method comprises: selecting a coating to have a refractive index to prevent leakage of light from the ridge-type hybrid laser.

In one embodiment, the method comprises: configuring the coating to prevent electrical conduction between an anode and cathode pair associated with the ridge-type hybrid laser.

In one embodiment, the method comprises: selecting: a crystalline, polycrystalline or amorphous material as said coating which has deposition characteristics which prevent damage, during deposition on said laser.

In one embodiment, the method comprises: depositing said coating on said laser.

In one embodiment, the method comprises: selecting a coating material to have a coefficient of thermal expansion matched to that of the laser.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figure 1a shows a scanning electron micrograph of an unencapsulated III-V hybrid laser device;
Figure 1b illustrates schematically a hybrid laser device such as that shown in Figure 1a;
Figure 2 illustrates graphically optical simulations of laser light confinement within a waveguide of a laser device as a function of encapsulate refractive index, n;
Figures 3a and 3b illustrate graphically simulation results of a hybrid laser thermal resistance as a function of MQW region effective thermal conductivity.

### DESCRIPTION OF THE EMBODIMENTS

Typical photonic integrated chip packages are such that they include a large thermoelectric cooler module provided to holistically cool an entire integrated circuit. Such a macro scale thermoelectric cooling module takes up a large region within a photonic integrated circuit package. Typically, there is a macroscopic gap between various heat-generating devices provided on the photonic integrated chip and the thermoelectric cooler. That is to say, there can be a significant distance between where heat is generated at an active device (for example, a laser) and where the thermoelectric cooling module is able to provide its cooling.

Aspects and embodiments recognise that a major drawback with existing cooling solutions can be the very large heat flux levels generated at small length scales by, for example, laser devices provided on a photonic integrated circuit, that are not adequately spread. That lack of spreading can result in large thermal resistances between a heat source and heat sink. Large local thermal resistance can result in lasers operating in a much higher temperature than is necessary or than is optimum. This means that the wall plug efficiency of laser devices can be in the region of an order of magnitude less than may be possible if they were provided with good integrated thermal solutions. Such an efficiency claim can be related to the I²R term in the p-doped region of such a device at roll-over laser powers rather than the quantum efficiency of the MQW region of such devices.

It has been recognised that it is possible to improve heat removal from, for example, laser devices provided on a photonic integrated circuit by extending across a polymer encapsulate provided around the active device such that it makes contact with a substrate. Such an arrangement can improve the thermal performance somewhat but still does not effectively deal with the spreading of heat away from the device since most of the heat generating region is adjacent to the polymer which is a poor thermal conductor.

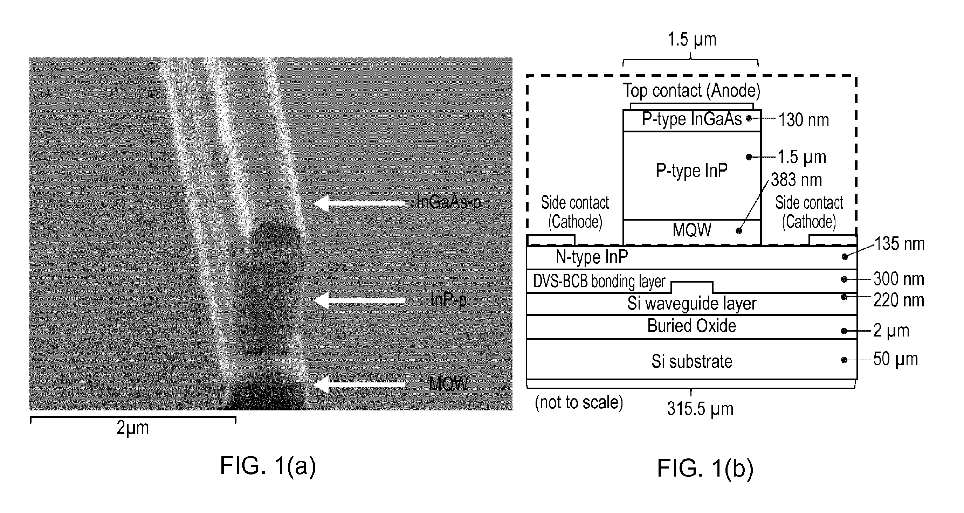

Figure 1a is a scanning electron micrograph of an unencapsulated III-V hybrid laser device. The device shown in Figure 1a comprises a multiple quantum well region (MQW) on top of which a p-doped indium phosphide (InP) layer is formed and a p-doped indium gallium arsenide (InGaAs) region on top of that.

Figure 1b illustrates schematically a cross-sectional view of a hybrid ridge type laser as shown in Figure 1a. The schematic shown in Figure 1b includes typical device dimensions. It can be seen that the ridge type hybrid laser which comprises the MQW layer and p-type indium phosphide and indium gallium arsenide regions has been arranged on a silicon substrate which includes a silicon waveguide layer. The silicon substrate waveguide layer is provided with a divinyl siloxane bisbenzocyclobutene (DVS BCB) coating upon which the ridge type hybrid laser device is bonded. The laser device is aligned with the silicon waveguide provided on the silicon substrate. In a known ridge type hybrid laser arrangement the ridge type laser can be encapsulated in a polymer. The dashed line in Figure 1B indicates the typical encapsulated volume. In known arrangements that volume is typically filled with benzocyclobutene (BCB) polymer. That encapsulate is chosen on the basis of its optical characteristics and acts to protect the ridge type hybrid laser.

In alternative embodiments, a hybrid laser device may be bonded directly to a substrate without an intervening DVS BCB layer or using an oxide or nitride intervening layer.

It has been recognised that heat removal from such laser devices can be improved by extending the p-contact (anode) which may be formed as a gold film to extend over the polymer encapsulate to make contact with the substrate. Such a configuration can improve thermal performance somewhat, but still does not particularly effectively deal with the spreading of heat away from the ridge type hybrid laser since most of the heat generating region is still provided in a polymer which conducts thermal heat poorly.

### Overview

Before discussing the embodiments in any more detail, first an overview will be provided.

Aspects and embodiments recognise that it is possible to replace known polymer encapsulates for hybrid ridge lasers with a more carefully chosen encapsulate material. That encapsulate material may be selected to have particular thermal and optical properties. Aspects and embodiments recognise that a deposited nitride, oxide or diamond encapsulate may be chosen and that appropriate selection of encapsulate material may reduce the overall thermal resistance of a device. The encapsulate material may function as an efficient heat-spreading layer if they are chosen to have high thermal conductivity, appropriate dielectric properties and suitable optical properties.

For example, the use of aluminium nitride (AlN) is preferred over an existing polymer encapsulate. The thermal conductivity of aluminium nitride ranges from k_{AlN} approximately equal to 20W/mK (for aluminium nitride having amorphous or polycrystalline form with nanometric grain sizes) to k_{AlN} approximately equal to 300W/mK for a completely crystalline form of aluminium nitride. The form of aluminium nitride which can be used as an encapsulate may depend upon selection of appropriate processing conditions. Those figures compare to the significantly lower thermal conductivity of BCB of k_{BCB} approximately equal to 0.2 - 0.3W/mK.

Other appropriate encapsulate materials according to aspects and embodiments described herein include, for example, boron nitride (BN), diamond (D), beryllium oxide (BO), zinc selenide (ZnS), magnesium fluoride (MgF) and silicon carbide (SiC).

Those materials selected as an appropriate encapsulate may display a combination of the following five characteristics:
As a result of the construction of a ridge-type hybrid laser, if an element is to be provided adjacent a surface of the laser to transfer heat away from that laser surface, there may be a need for the material to be electrically insulating to prevent electrical shorting between an anode and cathode associated with operation of the laser.

In order to effectively transfer heat away from a surface of the laser, any element or coating placed in contact with the ridge laser may be selected to have advantageous thermal properties. That is to say, the material may have low thermal resistance to allow for good heat transfer away from the laser.

Any material having a thermal conductivity greater than about 1W/mK (Watts per metre Kelvin) may be considered a thermally conductive material. Conversely, any material having a thermal conductivity of less than about 1W/mK may be considered to be substantially non-thermally conductive. Within the thermal conductivity range described above, a thermal conductivity greater than 100W/mK may be considered as a high thermal conductivity material and one within the range 1-100W/mK may be considered to have an acceptable thermal conductivity value.

Since the purpose of a ridge type laser is that of generation of light, the material may be selected to minimise leakage of light from the laser waveguide. In other words, the material can be selected to minimise coupling of light from the laser to the coating material.

The coating material may have mechanical properties selected to allow the coating to protect the ridge-type laser as appropriate. For example, the material may be selected to have a coefficient of thermal expansion matched to that of the ridge type laser, thereby mitigating chances of inducing mechanical strain damage to the laser, including, for example, strain induced layer separation or fracturing of the material forming the coating or the laser itself.

The coating material may be selected such that deposition techniques utilised to apply the coating to the surface of the laser are unlikely to cause damage to the laser construction. Deposition techniques typically require significant deposition temperatures. Such temperatures may exceed a temperature at which thermal damage may occur to said ridge laser. Such thermal damage may, for example, include delamination or separation of components forming said ridge type laser, or may include dopant diffusion from doped regions of said laser, resulting in functional damage to the operation of the laser.

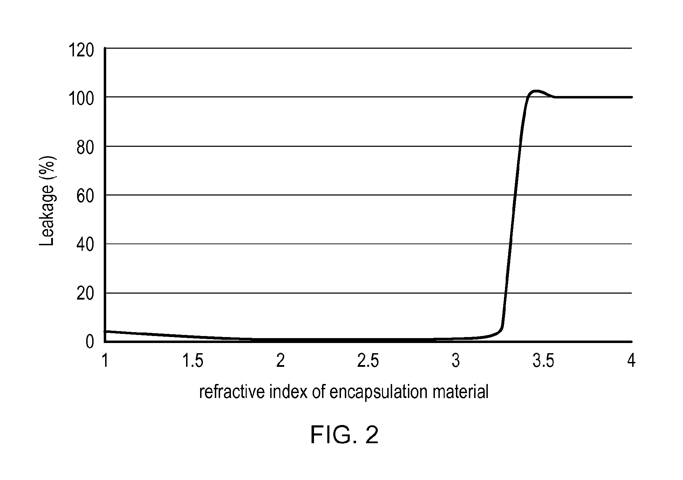

Figure 2 illustrates optical simulations of laser light confinement within the waveguide of the laser device as a function of encapsulate refractive index n. As can be seen from that Figure, for a refractive index of less than approximately 3.2, the encapsulate does not result in significant leakage from a laser waveguide; thus, such encapsulate is suited to use in such a laser arrangement in optical terms. In terms of the materials described in more detail below, the maximum refractive index of proposed encapsulates is in the region of n = 2.42 (diamond).

Together with optical properties, an appropriate encapsulate material may display further desirable characteristics. In particular, the encapsulate material chosen will typically not be an electrical conductor since there is a need to maintain electrical isolation between the anode and cathode.

Furthermore, the encapsulate material may be selected to have a good thermal conductivity.

Furthermore, encapsulation techniques using selected materials must be such that it is possible to encapsulate the ridge type hybrid laser without causing physical damage or potential physical damage to that ridge laser.

It will be appreciated that numerous methods to form encapsulate material may be employed.

It will also be appreciated that typically an arrangement of a ridge type hybrid laser such as that shown in Figures 1a and 1b will be realised by providing an appropriate silicon substrate then separately forming a layer structure which can function as a III-V hybrid laser, providing a DVS BCB bonding layer and bringing the silicon substrate and III-V layer structure together before selectively etching the III-V layer structure appropriately to form a ridge type hybrid laser which is aligned with a silicon waveguide provided in the silicon substrate. Encapsulate may be provided after the silicon substrate and III-V layer structure have been brought together and selectively etched. It will, of course, be appreciated that in alternative embodiments the hybrid laser device may be bonded directly to a substrate without an intervening DVS BCB layer.

According to some aspects and embodiments, an appropriate processing route could integrate crystalline layers of, for example, one or more of AlN, BN, D or BO in device structures using lower temperature processes which do not damage components during deposition. Although crystalline forms of such materials can be preferable to amorphous or polycrystalline forms since the thermal conductivity of the crystalline form may be in the region of one to two orders of magnitude greater, it is possible to use such amorphous or polycrystalline forms.

Numerous deposition methods are available for AlN, BN, D or BO where the method, substrate, seed layer and/or deposition temperature can determine the final crystal morphology. Such methods include: chemical vapour deposition (CVD), molecular beam epitaxy (MBE), pulsed laser deposition, atomic layer deposition, electron shower methods, ion beam deposition or RF, MF and DC magnetron reactive sputtering.

Crystalline AlN, BN, D or BO is most easily grown using CVD or MBE. Suitable buffer (seed) layers can be used to contain strain induced between the substrate and crystalline AlN, BN, D or BO layers. Those methods may require high temperatures of greater than around 600°C.

Physical vapour deposition methods include: pulsed laser deposition, electron shower methods, ion beam deposition or RF, MF and DC magnetron reactive sputtering. The crystal morphology of the associated deposited layer will typically be determined by various process conditions. For example, substrate temperature is one variable parameter according to which each of the physical deposition methods described can allow processing without direct heating of the substrate.

Appropriate control of processing parameters may allow the growth of amorphous material which can act as a buffer layer due to lattice mismatching with a substrate material. The amorphous layer can also function as a seed layer for deposition of a crystalline form of the heat spreading material whilst maintaining substrate temperatures at suitable levels to prevent damage to devices on or in the substrate.

According to some arrangements, ZnS or MgF may be deposited at relatively low temperatures using thermal evaporation or e-beam evaporation and the associated encapsulate material may achieve modest thermal conductivities in the region of k approximately equal to 30W/ mK.

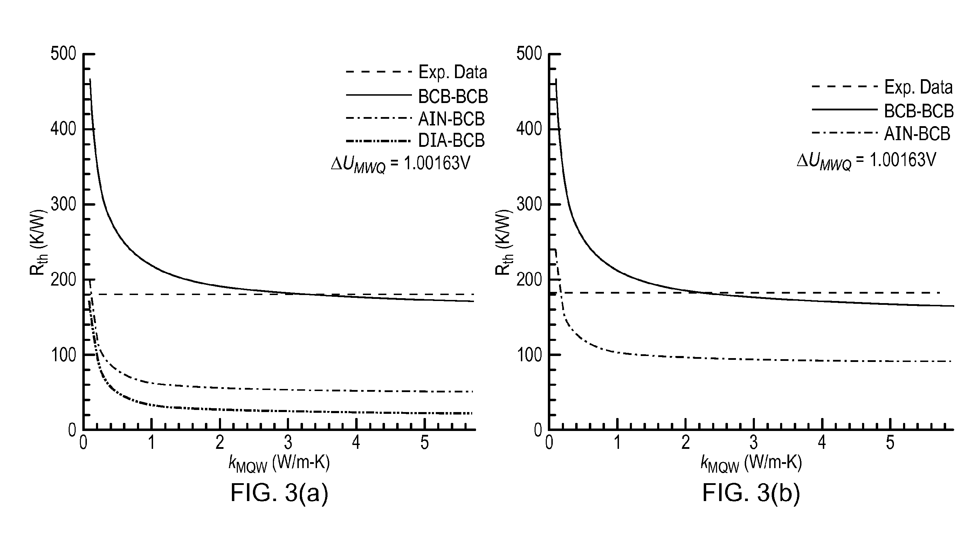

Figure 3 illustrates graphically the results of hybrid laser thermal resistance as a function of MQW region effective thermal conductivity. The standard dashed lines in Figures 3a and 3b (labelled exp.data) relate to experimentally determined thermal resistance of a hybrid laser device derived from optical measurements (R_{th,exp} = 182 K/W). In Figure 3a the simulation predictions for crystalline AlN as an encapsulate material (K_{AlN} = 136 W/mK) and diamond (k_{d} = 2000 W/mK) with a BCB bonding layer between the laser and the substrate are shown. The model indicates that the thermal resistance of the hybrid laser device can be reduced by approximately 3.4 times (R_{th,AlNc} = 54 K/W) and 7.1 times (R_{th,Dc} = 25.6 K/W) for crystalline AlN and diamond respectively. In Figure 3b the simulation predicts for amorphous (or polycrystalline with nanometric grain sizes) AlN with a BCB bonding layer between the laser and the substrate are such that the thermal resistance of a hybrid laser device can be reduced by 1.98 times (R_{th,AlNa} = 92 K/W).

It will be appreciated that aspects and embodiments recognise that a thermal solution can be implemented to enable energy efficient, scalable, reliable and low cost cooling designs for integrated photonics devices. An arrangement in accordance with aspects and embodiments described herein can provide improved thermal performance of a hybrid ridge type laser device. Such improved thermal performance can facilitate better temperature control, and lower device temperature can result in better device performance and longer device lifetimes. The expected thermal performance of the encapsulate materials described herein is illustrated in Figure 3 which shows a sample set of numerical simulations which cover the range of thermal conductivities for possible encapsulate materials.

Aspects and embodiments help to provide an integrated thermal approach which can deal with thermal spreading close to where heat on a device is generated within a laser waveguide.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/ or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A device comprising:
a ridge-type hybrid laser; and
a thermally conductive, electrically insulating, coating adjacent a surface of said ridge-type hybrid laser; said coating being configured to transfer heat away from said laser.

2. A device according to claim 1, wherein said coating has a thermal conductivity greater than about 1W/mK.

3. A device according to claim 1 or claim 2, comprising a substrate upon which said laser is arranged; said coating being configured to transfer heat away from said laser toward said substrate.

4. A device according to any preceding claim, wherein said coating is adjacent a portion of said surface.

5. A device according to any preceding claim, wherein said coating is adjacent an active region of said ridge-type hybrid laser.

6. A device according to any preceding claim, wherein said coating surrounds said active region.

7. A device according to any preceding claim, wherein said coating encapsulates said active region.

8. A device according to any preceding claim, wherein said coating is arranged between said surface and a substrate on which said ridge-type laser is arranged.

9. A device according to any preceding claim, wherein said coating has a refractive index selected to prevent leakage of light said ridge-type hybrid laser.

10. A device according to any preceding claim, wherein said coating is configured to prevent electrical conduction between an anode and cathode pair associated with said ridge-type hybrid laser.

11. A device according to any preceding claim, wherein said coating comprises: a crystalline, polycrystalline or amorphous material selected to have deposition characteristics which prevent damage, during deposition to said laser.

12. A device according to any preceding claim, wherein said coating comprises: a material selected to have a coefficient of thermal expansion matched to that of said laser.

13. A device according to any preceding claim, wherein said coating comprises any one of: boron nitride (BN), diamond (D), beryllium oxide (BO), zinc selenide (ZnS), magnesium fluoride (MgF) or silicon carbide (SiC).

14. A method of providing a device, said method comprising:
providing a ridge-type hybrid laser; and
coating a surface of said ridge-type hybrid laser with a thermally conductive, electrically insulating coating, said coating being adjacent said surface; and
configuring said coating to transfer heat away from said laser

15. A method according to claim 14, comprising: selecting: a crystalline, polycrystalline or amorphous material as said coating which has deposition characteristics which prevent damage, during deposition on said laser.
